# EUROPEAN PATENT SPECIFICATION

(11) **EP 0 907 241 B1**
(45) Date of publication and mention of the grant of the patent: **30.11.2005**
(21) Application number: 98114324.1
(22) Date of filing: 30.07.1998
(51) Int. Cl.: H03H 9/17, H03H 9/58, H03H 9/10

(54) **Piezoelectric resonator and electronic component using the same**
Piezoelektrischer Resonator und elektronisches Bauelement damit
Résonateur piézoélectrique et composant électronique utilisant ce résonateur

(30) Priority: 01.10.1997 JP 28617797
(43) Date of publication of application: 07.04.1999
(73) Proprietor: MURATA MANUFACTURING CO., LTD., Nagaokakyo-shi Kyoto-fu (JP)
(72) Inventor: Unami, Toshihiko, c/o Murata Manufacturing Co. Ltd, Nagaokakyo-shi, Kyoto-fu (JP); Baba, Toshiyuki, c/o Murata Manufacturing Co. Ltd, Nagaokakyo-shi, Kyoto-fu (JP); Nishimura,Toshio, c/o Murata Manufacturing Co. Ltd, Nagaokakyo-shi, Kyoto-fu (JP); Kakuda, Tatsunori c/o Murata Manufacturing Co. Ltd, Nagaokakyo-shi, Kyoto-fu (JP); Yamazaki, Takeshi, Murata Manufacturing Co. Ltd, Nagaokakyo-shi, Kyoto-fu (JP); Takeshima, Tetsuo, Murata Manufacturing Co. Ltd, Nagaokakyo-shi, Kyoto-fu (JP); Kusabiraki, Shigemasa, Murata Manufacturing Co.Ltd, Nagaokakyo-shi, Kyoto-fu (JP); Kawai, Yutaka, c/o Murata Manufacturing Co. Ltd, Nagaokakyo-shi, Kyoto-fu 617-8555 (JP); Yoshino, Hirohide, Murata Manufacturing Co. Ltd, Nagaokakyo-shi, Kyoto-fu (JP)
(74) Representative: Zinnecker, Armin

(56) References cited:
- US-A- 5 438 232

## Description

### 1. Technical Field of the Invention

The present invention relates to piezoelectric resonators and electronic components using the piezoelectric resonators, and in particular, for example, to a piezoelectric resonator utilizing mechanical resonance, and an electronic component using it. Such a piezoelectric resonator is known e.g. from US 5 438 232.

### 2. Description of the Related Art

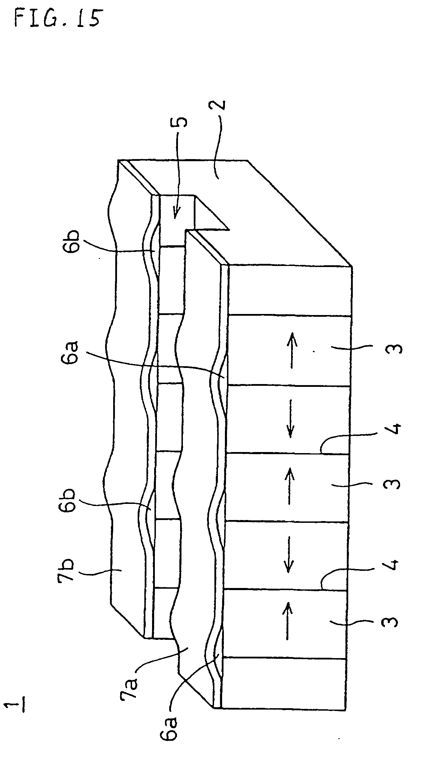

Piezoelectric resonators utilizing piezoelectric-member mechanical resonance include, for example, a piezoelectric resonator in which electrodes are provided on the surfaces of a piezoelectric plate polarized in its thickness direction. According to the piezoelectric resonator, applying an AC electric field across the electrodes excites the piezoelectric resonator to have a longitudinal vibration mode or radial vibration mode. However, this type of piezoelectric resonator utilizes an unstiffened mode in which electric field directions and polarization directions differ from vibration directions, and has a small electromechanical coupling coefficient and a relatively small difference ΔF between the resonant frequency and the antiresonant frequency. The use of the piezoelectric resonator utilizing the above-described unstiffened mode in an oscillator or piezoelectric filter causes disadvantages in which the bandwidth is small and a degree of freedom in characteristic design is low. Accordingly, in order to solve the disadvantages, the Applicant has proposed a layered piezoelectric resonator, shown in Fig. 15, as a stiffened-mode-utilized piezoelectric resonator having a large electromechanical coupling coefficient and a relatively large difference ΔF between the resonant frequency and the antiresonant frequency.

It is noted that the device shown in Fig. 15 is the subject of Applicant's copending Japanese Patent Application JP 1 005 126 which is not prepublished prior art to the present application.

Fig. 15 is an illustration showing one example of a piezoelectric resonator utilizing a stiffened mode. A piezoelectric resonator 1 includes a parallelepiped-shaped base member 2. The base member 2 is formed by alternately laminating a plurality of piezoelectric layers 3 and a plurality of internal electrodes 4. Two piezoelectric layers 3 which are adjacent with one internal electrode 4 provided between them are polarized in opposite directions in the longitudinal direction of the base member 2. In one side surface of the base member 2, a groove 5 is formed, and on one side of the groove 5, exposed portions of the internal electrodes 4 are alternately covered with insulating films 6a. On another side of the groove 5, the exposed portions of the internal electrodes 4, which are not covered with the insulating films 6a, are covered with other insulating films 6b. In addition, on both sides of the groove 5, thin-film external electrodes 7a, 7b are formed on the side surface of the base member 2. Accordingly, the adjacent internal electrodes 4 are respectively connected to the thin-film external electrodes 7a, 7b, which are different.

In the piezoelectric resonator 1, by applying a signal across the thin-film external electrodes 7a, 7b, an AC electric field is applied across the adjacent internal electrodes 4. The adjacent piezoelectric layers 3 are polarized in opposite directions. Thus, an AC electric field is applied to them, whereby the respective piezoelectric layers 3 expand or contract in the longitudinal direction of the base member 2, so that the whole of the base member 2 is excited to have a fundamental, longitudinal vibration mode. As described above, the piezoelectric resonator 1, which utilizes a stiffened mode in which electric field directions and polarization directions are the same as vibration directions, can increase an electromechanical coupling coefficient, compared with a piezoelectric resonator utilizing an unstiffened mode, and ΔF. Thus, using this type of piezoelectric resonator in an oscillator or filter enables a large bandwidth and a high degree of freedom in characteristic design.

In this type of piezoelectric resonator insulating films are formed on part of a side surface of a base, and thin-film external electrodes are formed on the film. Accordingly, the expansion or contraction of the insulating films due to a temperature change may break the thin-film external electrodes on the insulating films. When the thin-film external electrode are broken as described, no signal is applied to all internal electrodes, so that the piezoelectric resonator cannot function.

### SUMMARY OF THE INVENTION

Accordingly, a main object of the present invention is to provide a highly reliable piezoelectric resonator that can function, even if its thin-film external electrodes are broken. Another object of the present invention is to provide a highly reliable electronic component by using such a piezoelectric resonator.

The present invention provides a piezoelectric resonator, comprising: a base member having a longitudinal direction, formed by laminating a plurality of piezoelectric layers and a plurality of internal electrodes, the piezoelectric layers being polarized in the longitudinal direction of the base member, and the base member being vibrated in a longitudinal vibration mode by applying electric fields in the longitudinal direction of the base member; first insulating films disposed on a side surface of the base member so as to cover at least a part of exposed portions of a first group of the internal electrodes; and a first thin-film external electrode continuously provided in the longitudinal direction of the base member on the first insulating films; characterized by further comprising second insulating films disposed on the side surface of the base member so as to cover at least a part of the exposed portions of a second group of the internal electrodes, which are not covered with the first insulating films; a second thin-film external electrode continuously provided in the longitudinal direction of the base member on the second insulating films; and a first conductive resin film and a second conductive resin film respectively provided on the first thin-film external electrode and the second thin-film external electrode.

In the above described piezoelectric resonator, the first insulating films and the second insulating films may be respectively provided widthwise at one end and another end of the base member on one identical side surface of the base member. In addition, the first insulating films and the second insulating films may be provided on different side surfaces of the base member.

The present invention further provides an electronic component including the above described piezoelectric resonator, wherein the electronic component includes a substrate provided with pattern electrodes to which the conductive resin films are electrically connected, and the substrate is covered with a cap for covering the piezoelectric resonator.

In the above described electronic component, the plurality of electrodes may be provided on the insulating substrate and the conductive resin films of the plurality of piezoelectric resonators are electrically connected to the pattern electrodes so that a ladder filter is provided.

According to the piezoelectric resonator of the present invention, a first thin-film external electrode and a second thin-film external electrode are respectively connected to one of the first group of internal electrodes and one of the second group of internal electrodes by first insulating films and second insulating films. Conductive resin films are formed on the first thin-film external electrode and the second thin-film external electrode, whereby, even if the thin-film external electrode and the second thin-film external electrode are broken, the conductive films maintain thin-film-external-electrode conduction on both sides of a breakage. By supplying a signal to the conductive resin films on the first and second thin-film external electrodes, an ac electric field is applied to the piezoelectric layers, so that a base member is excited to have a longitudinal vibration mode.

In addition, by using the piezoelectric resonator for an electronic component, an electronic component can be obtained which, if thin-film external electrodes are broken, its characteristics can be maintained. In particular, in the case of a ladder filter using a plurality of piezoelectric resonators, even if the thin-film external electrodes of one piezoelectric resonator are broken, the ladder filter function can be secured to enhance the reliability.

To summarize, according to the present invention, even if thin-film external electrodes are broken by the expansion or contraction of an insulating film due to a temperature change, the function of a resonator cannot be damaged by the existence of conductive resin films, so that a highly reliable piezoelectric resonator can be obtained. Similarly, also, in an electronic component using this piezoelectric resonator, high reliability can be established. In addition, by changing the coating amount and shape of the conductive resin films, a damping of the vibration in a base member can be changed and Qm of the resonator can be changed. Therefore, a degree of freedom in designing a piezoelectric resonator and an electronic component can be obtained.

The above-described objects, other objects, features and advantages of the present invention will be apparent from the following description of embodiments with reference to the drawings.

### BRIEF DESCRIPTION OF THE DRAWINGS

Fig. 1 is a perspective view showing a preferred embodiment of a piezoelectric resonator according to the present invention.
Fig. 2 is an illustration of the piezoelectric resonator shown in Fig. 1.
Fig. 3 is a perspective view showing a condition in which ceramic green sheets are laminated to produce the piezoelectric resonator shown in Fig. 1.
Fig. 4 is an illustration showing a laminate base made of the ceramic green sheets shown in Fig. 3.
Fig. 5 is an illustration showing a section of the laminate base shown in Fig. 4.
Fig. 6 is an illustration showing a laminate formed by cutting the laminate base shown in Fig. 4.
Fig. 7(a) and Fig. 7(b) are illustrations respectively showing a plan view and a side view of a condition in which the laminate shown in Fig. 6 is provided with an insulating film.
Fig. 8(a) and Fig. 8(b) are illustrations respectively showing a plan view and a side view of a condition in which the laminate shown in Fig. 7 is provided with a thin-film external electrode and a conductive resin film.
Fig. 9 is an illustration showing a step in which grooves are formed in the laminate shown in Fig. 8, and it is cut to produce piezoelectric resonator.
Fig. 10 is an illustration another preferred embodiment of a piezoelectric resonator according to the present invention.
Fig. 11 is an illustration a further preferred embodiment of a piezoelectric resonator according to the present invention.
Fig. 12 is an exploded perspective view showing a preferred embodiment of an electronic component in which a piezoelectric resonator of the present invention is used.
Fig. 13 is an exploded perspective main-component view showing a preferred embodiment of a ladder filter in which a piezoelectric resonator of the present invention is used.
Fig. 14 is an equivalent circuit diagram of the ladder filter shown in Fig. 13.
Fig. 15 is an illustration showing one example of a piezoelectric resonator as the background of the present invention.

### DESCRIPTION OF PREFERRED EMBODIMENTS

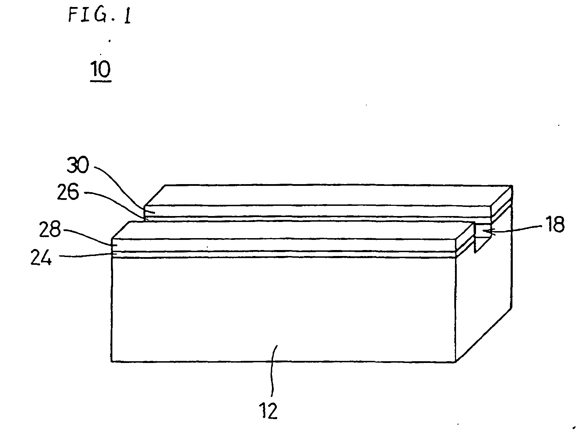

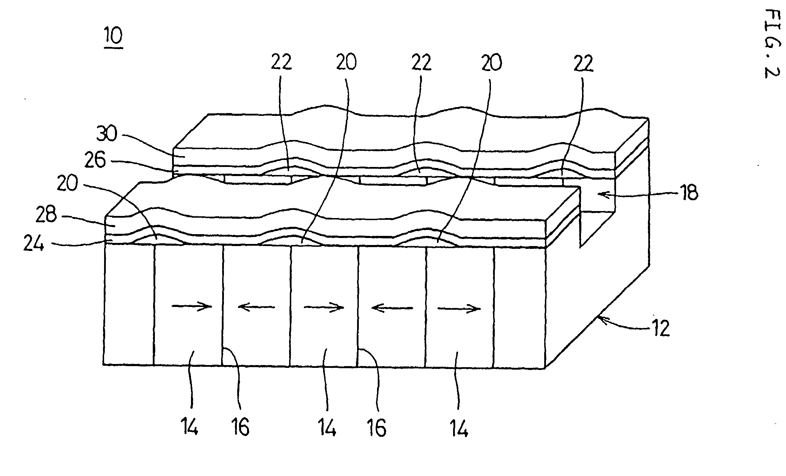

Fig. 1 is a perspective view showing one preferred embodiment of a piezoelectric resonator of the present invention, and Fig. 2 is an illustration of the embodiment. A piezoelectric resonator 10 includes a pillared base member 12. The base member 12 is formed by alternately laminating a plurality of piezoelectric layers 14 and internal electrodes 16. As indicated by the arrows in Fig. 2, one piezoelectric layer 14 between two adjacent internal electrodes 16, and one piezoelectric layer 14 adjacent with one internal electrode 16 provided between them are polarized in opposite directions in the longitudinal direction of the base member 12. However, the piezoelectric layers 14, which are at the ends of the base member 12 in its longitudinal direction, are not polarized. The ends of the base member 12 may be polarized if necessary. Also, in the case where piezoelectric layers not polarized are formed, the formation positions in the base member 12 are arbitrary.

On one side surface of the base member 12, in the center of its width, a groove 18 extending in the longitudinal direction of the base member 12 is provided. On one side of the groove 18, exposed portions of the internal electrodes 16 are coated with first insulating films 20, with one portion uncoated. On another side of the groove 18, the exposed portions of the internal electrodes 16, which are not coated with the first insulating films 20, are coated with second insulating films 22. Accordingly, on both sides of the groove 18, the exposed portions of the internal electrodes 16 are alternately coated with the first insulating films 20 and the second insulating films 22.

In addition, on one side of the groove 18, and on the side surface of the base member 12 on which the first insulating films 20 are formed, a first thin-film electrode 24 is formed. Thus, a first group of the internal electrodes 16, which are not coated with the first insulating films 20, are electrically connected to the first thin-film electrode 24. Also, on another side of the groove 18, and on the side surface of the base member 12 on which the second insulating films 22 are formed, a second thin-film external electrode 26 is formed. Thus, a second group of the internal electrodes 16, which are not coated with the second insulating films 22, are electrically connected to the second thin-film external electrode 26. The internal electrodes 16 formed in the base member 12 do not always need to be alternately connected to different thin-film external electrodes. For example, the internal electrodes 16, which are adjacent, may be connected to one identical thin-film external electrode, or may include an internal electrode not completely connected to a thin-film external electrode. The groove 18 may be provided if necessary, and does not always need to be provided.

On the first thin-film external electrode 24, a conductive resin film 28 is provided. Thus, the conductive resin film 28 is electrically connected to the first thin-film external electrode 24. Also, on the second thin-film external electrode 26, a second conductive resin film 30 is provided. Thus, the second conductive resin film 30 is electrically connected to the second thin-film external electrode 26.

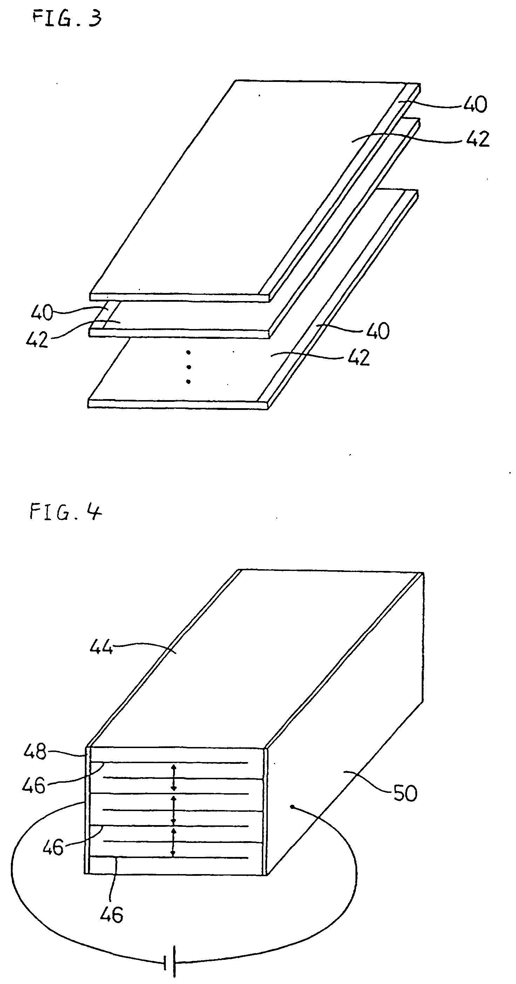

To produce the piezoelectric resonator 10, piezoelectric ceramic green sheets 40 are initially prepared as shown in Fig. 3. Conductive paste including, for example, silver, palladium, an organic binder, etc. is applied on one surface of one green sheet 40 to form a conductive paste layer 42. The conductive paste layer 42 is formed on the whole of the surface excluding one end of the green sheet 40. The plurality of green sheets 40 are laminated. At this time, the green sheets 40 are laminated so that their ends on which the conductive paste layers 42 are not formed are arranged in opposite directions. By applying the conductive paste on the opposing sides of the laminate and burning it, a laminate base 44 as shown in Fig. 4 is formed. Here, for convenience of description, an eight-layered green-sheet laminate is described. However, as shown in Fig. 2, this is similar to the case where a seven-layered laminate is produced.

In the laminate base 44, the plurality of internal electrodes 46 are formed by burning the conductive paste layers 42. The internal electrodes 46 are alternately exposed from opposing portions of the laminate base 44. On the opposing portions of the laminate base 44, polarizing electrodes 48, 50 alternately connected to the internal electrodes 46 are formed. By applying a dc voltage across the polarizing electrodes 48, 50, the polarization of the laminate base 44 is performed. At this time, in the laminate base 44, dc high electric fields are applied to the internal electrodes 46, which are adjacent, and their directions are alternately reverse. Accordingly, the laminate base 44 is polarized in opposite directions on both sides of each internal electrode 46, as indicated by the arrows in Fig. 4.

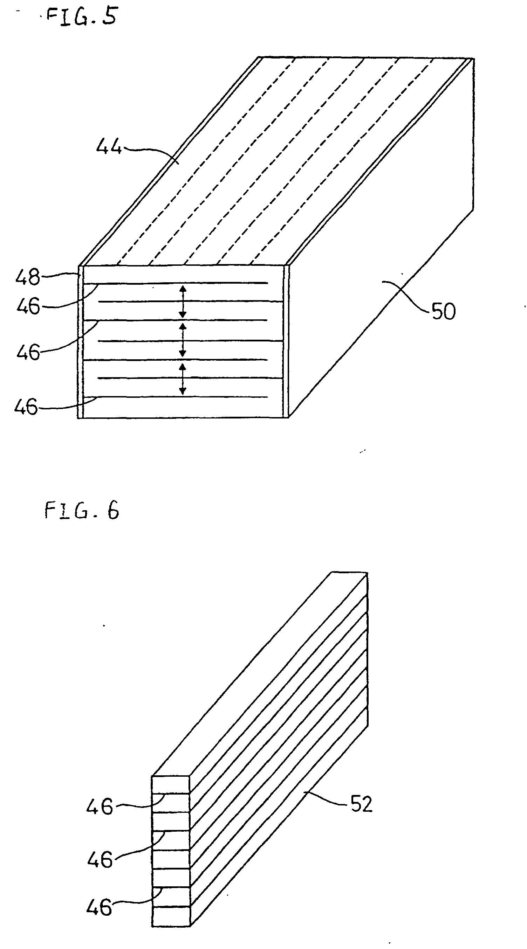

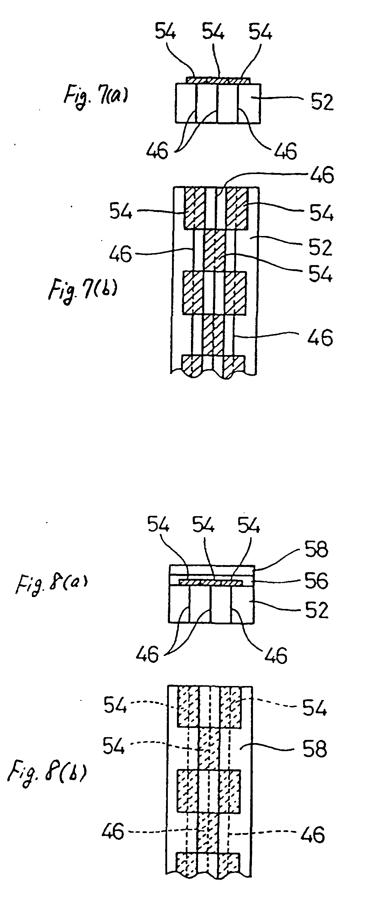

Next, as indicated by the dotted lines in Fig. 5, the laminate base 44 is cut so as to be orthogonal to the internal electrodes 46 by a dicer or the like. This forms a laminate 52 in which ends of the internal electrodes 46 are exposed, as shown in Fig. 6. As shown in Fig. 7, one side surface of the laminate 52, insulating films 54 are formed so as to be checked. Fig. 7 is a simplified figure of Fig. 6, in which a reduced number of layers is shown. One row of checked insulating films 54, orthogonal to the internal electrodes 46, are alternately formed on the internal electrodes 46. On one adjacent checked row, the insulating films 54 are formed on the internal electrodes 46, on which the insulating films 54 are not formed on an adjacent row.

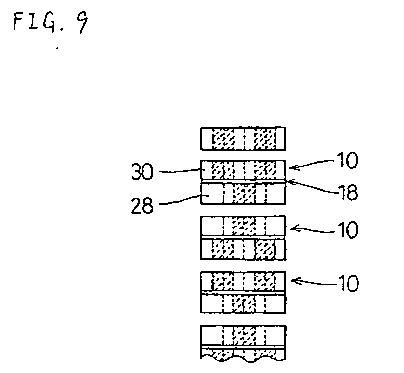

As shown in Fig. 8, on the surface of the laminate 52 on which the insulating films 54 are formed, a thin-film external electrode 56 is formed by sputtering etc. On the thin-film external electrode 56, a conductive resin film 58 is formed. As shown in Fig. 9, between adjacent rows of checked insulating films 54, a groove 18 is formed so as to be orthogonal to the plane of the internal electrodes 46. By cutting the laminate 52 at the groove 18, the piezoelectric resonator 10 shown in Fig. 1 is formed.

In the piezoelectric resonator 10, by applying a signal across the first conductive resin film 28 and the second conductive resin film 30, opposite voltages are applied to the piezoelectric layers 14 of the base member 12, which are oppositely polarized, which causes the piezoelectric layers 14 to expand or contract. Accordingly, the whole of the piezoelectric resonator 10 is excited to have fundamental vibration as a longitudinal vibration mode, with the central portion of the base member 12 used as a node.

In the piezoelectric resonator 10, the polarization directions of the piezoelectric layers 14, the directions of the signal-caused electric fields are the same as the vibration directions of the base member 12. In other words, the piezoelectric resonator 10 is a stiffened piezoelectric resonator. This stiffened piezoelectric resonator 10 has an electromechanical coupling coefficient larger than that of an unstiffened piezoelectric resonator in which polarization directions and electric field directions differ from vibration directions.

The first and second conductive resin films 28, 30 are formed on the first and second thin-film external electrodes 24, 26. Thus, even if the first and second thin-film external electrodes 24, 26 are broken by the expansion or contraction of the first and second insulating films 20, 22 due to a temperature change etc., conduction on the sides of a breakage in the thin-film external electrode 24 or 26 is secured by the conductive resin films 28, 30. Accordingly, if the thin-film external electrodes 24, 26 are broken, the piezoelectric resonator 10 can be normally excited.

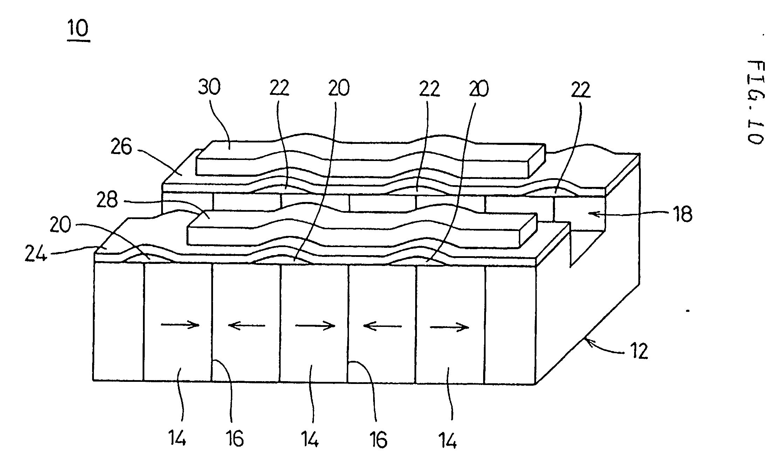

The first conductive resin film 28 and the second conductive resin film 30 do not need to be formed on the whole of the first thin-film external electrode 24 and the whole of the second thin-film external electrode 26. They may be partially formed as shown in Fig. 10. Also, in this type of piezoelectric resonator 10, when the thin-film external electrodes 24, 26, on which the insulating films 20, 22 are formed, are broken, their conduction is secured by the conductive resin films 28, 30. In addition, a conductive resin film has the function of damping the vibration of a piezoelectric resonator. Thus, as the areas of the conductive resin films 28, 30 increase, Qm of the piezoelectric resonator 10 decreases. Therefore, by changing the area or shape of the conductive resin film 28 or 30, Qm of the piezoelectric resonator 10 can be adjusted.

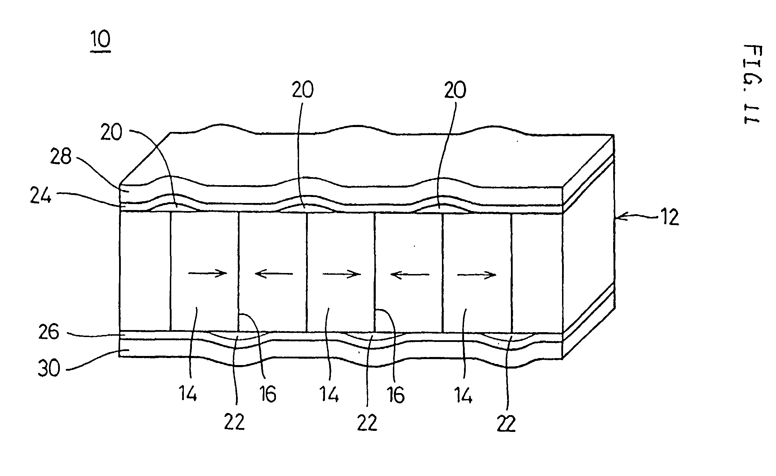

As shown in Fig. 11, first insulating films 20 and second insulating films 22 may be formed on the opposing side surfaces of a base member 12. In this case, on the opposing surfaces of the base member 12, different exposed portions of internal electrodes 16 are alternately coated with the first and second insulating films 20, 22. On the opposing surfaces of the base member 12 on which the insulating films 20, 22 are formed, first and second thin-film external electrodes 24, 26 are formed. On the first and second thin-film external electrodes 24, 26, first and second conductive resin films 28, 30 are formed. Also, in this piezoelectric resonator 10, the formed conductive resin films 28, 30 can prevent inferior connection due to breakage of the thin-film external electrodes 24, 26.

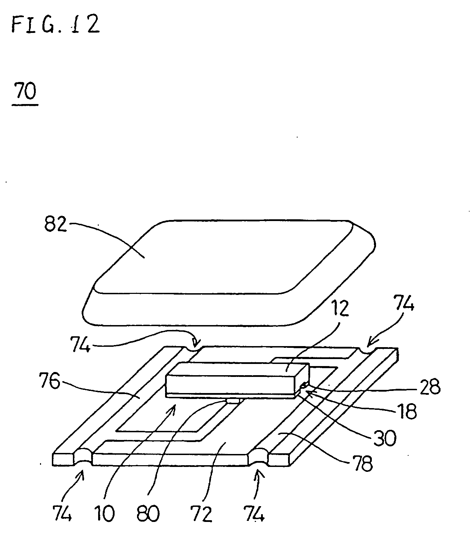

The above-described piezoelectric resonator 10 is used to produce electronic components such as an oscillator and a discriminator. Fig. 12 is a perspective view showing one example of an electronic component 70. The electronic component 70 includes an insulating substrate 72. At opposing ends of the insulating substrate 72, pairs of depressions are formed. On one surface of the insulating substrate 72, two pattern electrodes 76, 78 are formed. One pattern electrode 76 is formed between one pair of opposing depressions 74 so that its one end extends to the central portion of the insulating substrate 72 in the form of letter L. Another pattern electrode 78 is formed between another pair of opposing depressions 74 so that its other end extends to the central portion of the insulating substrate 72 in the form of letter L. The two pattern electrodes 76, 78 are formed near the center of the insulating substrate 72 so as to face each other, with a distance provided between them. Known substrates such as a glass-epoxy substrate, an alumina substrate, and a multi-layered substrate are used as the insulating substrate 72. Also one using a dielectric substrate or the like may be used.

In the longitudinal central portion of the base member 12, on the first and second conductive resin films 28, 30 of the piezoelectric resonator 10, a fixing member 80 including a conductive adhesive is formed, and the fixing member 80 is connected to and fixed on the pattern electrodes 76, 78 by conductive adhesives etc. (not shown) provided on the ends of the pattern electrode 76 and the pattern electrode 78 in the central portion of the insulating substrate 72. Thereby, the conductive resin films 28, 30 of the piezoelectric resonator 10 are fixed on the insulating substrate 72, and are electrically connected to the pattern electrodes 76, 78. And, the insulating substrate 72 is covered with a metal cap 82. At this time, insulating resin is applied on the insulating substrate 72 and the pattern electrodes 76, 78 so that the metal cap 82 and the pattern electrodes 76, 78 are not in conduction. After that, covering with the metal cap 82 produces the electronic component 70.

According to the electronic component 70, the fixing member 80, which is formed on the first and second conductive resin films 28, 30 of the piezoelectric resonator 10, disposes the ends of the piezoelectric resonator 10 to be away from the insulating substrate 72, so that the vibration is not hindered. The central portion of the piezoelectric resonator 10, which is a node, is securely fixed by the fixing member 80, whereby vibration leaking from the piezoelectric resonator 10 can be prevented.

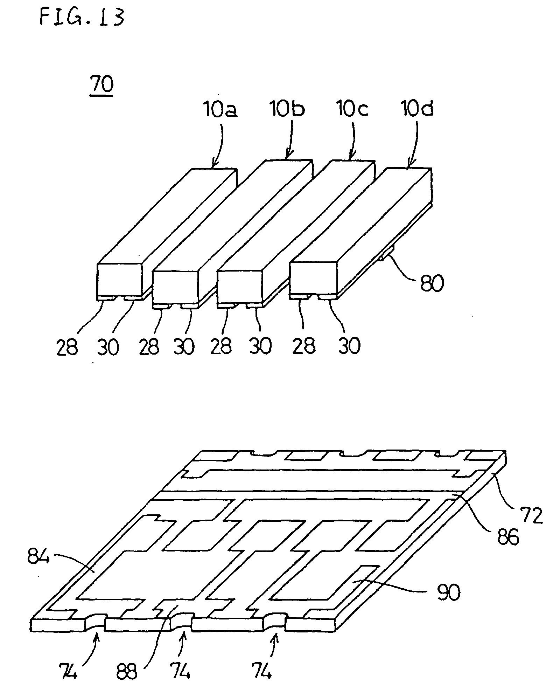

In addition, a plurality of piezoelectric resonators 10 are used to produce a ladder filter. Fig. 13 consists of perspective main-component views showing an example of an electronic component used as a ladder filter having a ladder circuit. In an electronic component 70 shown in Fig. 13, four pattern electrodes 84, 86, 88, 90 are formed on an insulating substrate 72. On the pattern electrodes 84 to 90, a row of five lands are formed at intervals. In this case, the first land from one end of the insulating substrate 72 is formed, the second and fifth lands are formed on the pattern electrode 86, the third land is formed on the pattern electrode 88, and the fourth land is formed on the pattern electrode 90.

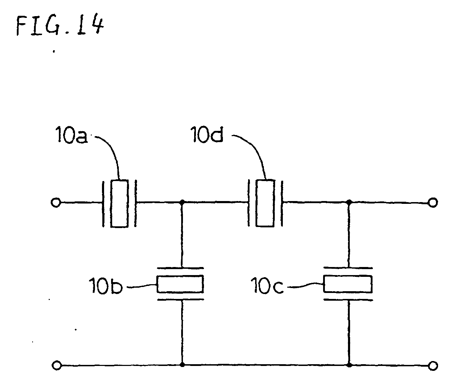

A piezoelectric resonator 10 in which a fixing member 80 is formed on the first and second conductive resin films 28, 30 is mounted on the fixing member 80 and each land of the substrate 72 by a conductive adhesive. In this case, piezoelectric resonators 10a to 10d are mounted so that a ladder circuit shown in Fig. 14 is obtained. The insulating substrate 72 is covered with a metal cap (not shown).

Concerning even the electronic component shown in Fig. 12 or Fig. 13, it can be made as a highly reliable electronic component in which the function of a piezoelectric resonator cannot be damaged by temperature-change-caused breakage of a thin-film external electrode.

While the invention has been particularly shown and described with reference to preferred embodiments thereof, it will be understood by those skilled man in the art that the forgoing and other changes in form and details may be made therein without departing from the scope of the invention as defined in the appended claims.

## Claims

1. A piezoelectric resonator (10), comprising:
a base member (12) having a longitudinal direction, formed by laminating a plurality of piezoelectric layers (14) and a plurality of internal electrodes (16), said layers being polarized in the longitudinal direction of said base member, and said piezoelectric base member being vibrated in a longitudinal vibration mode by applying electric fields in the longitudinal direction of said base member;
first insulating films (20) disposed on a side surface of said base member so as to cover at least a part of exposed portions of a first group of said internal electrodes; and a first thin-film external electrode (24) continuously provided in the longitudinal direction of said base member on said first insulating films; **characterized by** further comprising
second insulating films (22) disposed on the side surface of said base member so as to cover at least a part of exposed portions of a second group of said internal electrodes, which are not covered with said first insulating films;
a second thin-film external electrode (26) continuously provided in the longitudinal direction of said base member on said second insulating films; and
a first conductive resin film (28) and a second conductive resin film (30) respectively provided on said first thin-film external electrode and said second thin-film external electrode.

2. The piezoelectric resonator according to Claim 1, wherein said first insulating films and said second insulating films are respectively provided widthwise at one end and another end of said base member on one identical side surface of said base member.

3. The piezoelectric resonator according to Claim 1, wherein said first insulating films and said second insulating films are provided on different side surfaces of said base member.

4. An electronic component (70) including said piezoelectric resonator (10) of one of Claims 1 to 3, wherein said electronic component includes a substrate (72) provided with pattern electrodes (76,78) to which said conductive resin films (28,30) are electrically connected, and said substrate is covered with a cap (82) for covering said piezoelectric resonator.

5. An electronic component according to Claim 4, wherein the plurality of electrodes are provided on said insulating substrate and said conductive resin films of the plurality of piezoelectric resonators are electrically connected to said pattern electrodes so that a ladder filter is provided.

6. The electronic component according to claim 5, wherein:
first, second, third and fourth base members are provided as said base members;
first, second, third and fourth pattern electrodes (84,86,88,90) are provided as said electrode on said substrate; said first base member is mounted on said first and second pattern electrodes;
said second base member is mounted on said second and third pattern electrodes;
said third base member is mounted on said second and fourth pattern electrodes; and
said fourth base member is mounted on said third and fourth pattern electrodes.

## Patentansprüche

1. Piezoelektrischer Resonator (10), welcher umfasst:
- ein Grundelement (12) mit einer Längsrichtung, das durch Laminieren mehrerer piezoelektrischer Schichten (14) und mehrerer Innenelektroden (16) gebildet wird, wobei die piezoelektrischen Schichten in der Längsrichtung des Grundelements polarisiert werden und das Grundelement durch Anlegen elektrischer Felder in Längsrichtung des Grundelements in einer Längsschwingungsmode zum Schwingen gebracht wird;
- erste an einer Seitenfläche des Grundelements so angeordnete Isolierschichten (20), dass sie mindestens einen Teil von freiliegenden Teilen einer ersten Gruppe der Innenelektroden bedecken; und
- eine in Längsrichtung des Grundelements an den ersten Isolierschichten durchgehend vorgesehene erste Dünnschicht-Außenelektrode (24);
**dadurch gekennzeichnet, dass** er weiterhin umfasst:
- zweite an der Seitenfläche des Grundelements so angeordnete Isolierschichten (22), dass sie mindestens einen Teil von freiliegenden Teilen einer zweiten Gruppe der Innenelektroden bedecken, die nicht mit den ersten Isolierschichten bedeckt sind;
- eine in Längsrichtung des Grundelements an den zweiten Isolierschichten durchgehend vorgesehene zweite Dünnschicht-Außenelektrode (26); und
eine erste leitende Harzschicht (28) und eine zweite leitende Harzschicht (30), die an der ersten Dünnschicht-Außenelektrode bzw. an der zweiten Dünnschicht-Außenelektrode vorgesehen sind.

2. Piezoelektrischer Resonator nach Anspruch 1, **dadurch gekennzeichnet, dass** die ersten Isolierschichten und die zweiten Isolierschichten in Breitenrichtung an einem Ende bzw. am anderen Ende des Grundelements an einer identischen Seitenfläche des Grundelements vorgesehen sind.

3. Piezoelektrischer Resonator nach Anspruch 1, **dadurch gekennzeichnet, dass** die ersten Isolierschichten und die zweiten Isolierschichten an verschiedenen Seitenflächen des Grundelements vorgesehen sind.

4. Elektronisches Bauelement (70), welches den piezoelektrischen Resonator (10) nach einem der Ansprüche 1 bis 3 umfasst, wobei das elektronische Bauelement ein mit Strukturelektroden (76, 78) versehenes Substrat (72), mit dem die leitenden Harzschichten (28, 30) elektrisch verbunden sind, aufweist und das Substrat mit einer Abdeckung (82) für das Abdecken des piezoelektrischen Resonators versehen ist.

5. Elektronisches Bauelement nach Anspruch 4, **dadurch gekennzeichnet, dass** die mehreren Elektroden an dem isolierenden Substrat vorgesehen sind und die leitenden Harzschichten der mehreren piezoelektrischen Resonatoren mit den Strukturelektroden elektrisch so verbunden sind, dass ein Kaskadenfilter erzeugt wird.

6. Elektronisches Bauelement nach Anspruch 5, **dadurch gekennzeichnet dass**:
erste, zweite, dritte und vierte Grundelemente als Grundelemente vorgesehen werden;
erste, zweite, dritte und vierte Strukturelektroden (84, 86, 88, 90) als Elektrode an dem Substrat vorgesehen werden;
das erste Grundelement an den ersten und zweiten Strukturelektroden angebracht wird,
das zweite Grundelement an den zweiten und dritten Strukturelektroden angebracht wird;
das dritte Grundelement an den zweiten und vierten Strukturelektroden angebracht wird; und
das vierte Grundelement an den dritten und vierten Strukturelektroden angebracht wird.

## Revendications

1. Résonateur piézoélectrique (10), comprenant :
un élément de base (12) qui présente une direction longitudinale, formé en empilant une pluralité de couches piézoélectriques (14) et une pluralité d'électrodes internes (16), lesdites couches piézoélectriques étant polarisées suivant la direction longitudinale dudit élément de base, et ledit élément de base étant vibré dans un mode vibration longitudinale en appliquant des champs électriques suivant la direction longitudinale dudit élément de base ;
des premiers films isolants (20) qui sont disposés sur une surface latérale dudit élément de base de manière à recouvrir au moins une partie de portions exposées d'un premier groupe desdites électrodes internes ; et
une première électrode externe en film mince (24) qui est prévue en continu suivant la direction longitudinale dudit élément de base sur lesdits premiers films isolants,
**caractérisé en ce qu'**il comprend en outre :
des seconds films isolants (22) qui sont disposés sur la surface latérale dudit élément de base de manière à recouvrir au moins une partie de portions exposées d'un second groupe desdites électrodes internes, qui ne sont pas recouvertes desdits premiers films isolants ;
une seconde électrode externe en film mince (26) qui est prévue en continu suivant la direction longitudinale dudit élément de base sur lesdits seconds films isolants ; et
un premier film en résine conducteur (28) et un second film en résine conducteur (30) qui sont respectivement prévus sur ladite première électrode externe en film mince et sur ladite seconde électrode externe en film mince.

2. Résonateur piézoélectrique selon la revendication 1, dans lequel lesdits premiers films isolants et lesdits seconds films isolants sont respectivement prévus suivant la largeur au niveau d'une extrémité et au niveau d'une autre extrémité dudit élément de base sur une surface latérale identique dudit élément de base.

3. Résonateur piézoélectrique selon la revendication 1, dans lequel lesdits premiers films isolants et lesdits seconds films isolants sont prévus sur des surfaces latérales différentes dudit élément de base.

4. Composant électronique (70) incluant ledit résonateur piézoélectrique (10) selon l'une des revendications 1 à 3, dans lequel ledit composant électronique inclut un substrat (72) qui est muni d'électrodes de motif (76, 78) sur lesquelles lesdits films en résine conducteurs (28, 30) sont connectés électriquement, et ledit substrat est recouvert d'un capuchon (82) pour recouvrir ledit résonateur piézoélectrique.

5. Composant électronique selon la revendication 4, dans lequel les électrodes de la pluralité d'électrodes sont prévues sur ledit substrat isolant et lesdits films en résine conducteurs de la pluralité de résonateurs piézoélectriques sont connectés électriquement auxdites électrodes de motif de telle sorte qu'un filtre en échelle soit constitué.

6. Composant électronique selon la revendication 5, dans lequel :
des premier, second, troisième et quatrième éléments de base sont prévus en tant que dits éléments de base ;
des première, seconde, troisième et quatrième électrodes de motif (84, 86, 88, 90) sont prévues en tant que dites électrodes sur ledit substrat ;
ledit premier élément de base est monté sur lesdites première et seconde électrodes de motif ;
ledit second élément de base est monté sur lesdites seconde et troisième électrodes de motif ;
ledit troisième élément de base est monté sur lesdites seconde et quatrième électrodes de motif ; et
ledit quatrième élément de base est monté sur lesdites troisième et quatrième électrodes de motif.
